(19) Europäisches Patentamt
European Patent Office
Office européen des brevets

(11) **EP 1 780 550 A1**

(12) **EUROPEAN PATENT APPLICATION**

(43) Date of publication:
**02.05.2007 Bulletin 2007/18**

(51) Int Cl.:
***G01R 1/067*** (2006.01)

(21) Application number: **05388093.6**

(22) Date of filing: **31.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Capres A/S
2800 Lyngby (DK)**

(72) Inventors:
• **Petersen, Dirch
2800 Kgs. Lyngby (DK)**

• **Hansen, Torben Mikael
2100 Köbenhavn (DK)**
• **Petersen, Peter Rasmus Ebsen
3400 Hilleröd (DK)**

(74) Representative: **Orsnes, Henrik Egede et al
Budde, Schou & Ostenfeld
Vester Sögade 10
1601 Copenhagen V (DK)**

(54) **A probe for testing electrical properties of test samples**

(57)  The present invention relates to a probe (502) for testing electrical properties of test samples (508). The probe may comprise a body (504) having a probe arm (506) defining a proximal and an opposite distal end, the probe arm (506) extending from the body at the proximal end of the probe arm, a first axis defined by the proximal and the distal end. Further, the probe arm may define a geometry allowing flexible movement of the probe arm along the first axis and along a second axis perpendicularly to the first axis and along a third axis orthogonal to a plane defined by the first axis and second axis.

Fig. 7

**Description**

The present invention relates to a system and method for calculation correction factors for reducing or eliminating positional errors in resistance measurements and to a method and system for performing resistance measurements for determining the sheet resistance of test samples. The present invention further relates to a probe for testing electrical properties of test samples.

Related systems and methods may be found in publications such as US 2004/0183554, US 6,943,571, US 4,703,252, US 5,691,648, US 6,747,445, US 2005/0151552, US 2005/0081609 and US 2005/0062448. Reference is made to all of the above-mentioned US patent publications, all of which are hereby incorporated in the present specification by reference in their entirety for all purposes.

When performing resistance measurements determining the resistance of a test sample, the surface of the test sample and the way that a probe used for performing the measurements are brought into contact with the surface of the test sample errors induced by the fact that probe arms of the test probe are positioned so that the distances between individual probes varies from the assumed distances and the current distribution in the surface of the test sample therefore is not as assumed. The present invention provides a method and system for eliminating in-line positional errors especially four-point probe resistance measurements.

According to the first aspect of the present invention, a method for calculating a correction factor for reduction of positional errors in resistance measurements using four-point probes. The four-point probe having a body and four probe arms each including a probe, the probe arms extending parallel from the body, the four-point probe including electrical contact points for establishing electrical contact between the probes and a test apparatus transmitting and receiving electrical signals, the method may comprise the steps of:

positioning the probe arms in contact with a surface of the test sample,
selecting a first set comprising a first and a second probe arm and a second set comprising a third and a fourth probe arm,
applying a first current from the test apparatus through the first probe arm of the first set to the second probe arm of the first set, the first current propagating through the test sample,
detecting a first induced voltage between the third and probe arms of the second set,
calculating a first four-point resistance, $R_{first}$, being a ratio of the first voltage and the first current,
selecting a third set comprising a first and a second probe arm, wherein the third set includes no more than one of the probe arms of the first set, and a fourth set comprising a third and a fourth probe arm wherein the fourth set includes no more than one of the probe arms of the second set,
applying a second current from the test apparatus through the first probe arm of the third set to the second probe arm of the third set, the second current propagating through the test sample,
detecting a second induced voltage at the third and probe arms of the fourth set,
calculating a second four-point resistance, $R_{second}$, being a ratio of the second voltage and the second current,
calculating a correction factor, based on the first and second four-point resistances.

Although the present invention is directed at four-point probes, the probes may include more than four probe arms each including at least one probe and measurements may eg. be performed using four of these probes. Also, the probe arms need not extend parallel from the probe body, but the probes, at the end of the probe arms, are preferably arranged on a line, meaning that the probe arms may have other geometrical configurations than linear or rectangular.

The probe and the test sample is preferably arranged in a test apparatus having two or more holders for holding the test sample and probe, respectively. The test probe and the test sample is brought into contact with each other, either by moving the test probe or the test sample or both so that these are brought into contact. The verification of contact between the test probe and the test sample may be verified, eg. optically/visually or using electrical methods for verifying the contact.

Ideally the surface of the test sample is flat and the probe arms of the test probe are brought into contact with the surface of the test sample so that the probes are positioned in-line having a pre-defined or known spacing, however, as this is not the case in the real world, the present invention provides a method for calculating an improved correction factor for reducing or eliminating the errors caused by the non-ideal positioning of the probes on the surface of the test sample.

In the four-point probe, a first set comprising two probe arms of the four-probe arms of the test probe is selected and a second group comprising two probe arms different from the probe arms of the first set is selected. A current is applied to one of the probe arms of the first set whereby the current is propagated through the surface of the test sample. A voltage is thereby induced in the test sample. This induced voltage may then be measured or determined using the first and second probe arms of the second set of probe arms.

From the applied current and the measured voltage a four-point resistance may be calculated as the ratio between the voltage and the current. The sheet resistance may also be measured.

A third set comprising a first and a second probe arm is selected and provided the probe includes only four probe arms, the said may include only one of the probe arms of the first set or alternatively the second set. A fourth set of probe arms are selected wherein the probe arms of the fourth set includes no more than one of the probe arms of the second set or alternatively first set.

A second current is then applied on the probe arms of the third set, or in the alternative on the probe arms of the fourth set. As the current propagates through the surface of the test sample a voltage is induced which may be determined or measured at the probe arms of the fourth set, alternatively third set. As before, a four-point sheet resistance may be calculated based on the ratio of the second voltage and the current.

In one embodiment, the calculation of the correction factor by the relation between two four-point resistances given by $R_{first}/R_{second} = 1-(\ln(1-\gamma)/\ln(\gamma))$. A correction factor is then given by $C_{second} = 2\pi / \ln(\gamma)$ and the sheet resitance by $R_{sq} = C_{second} R_{second}$

The factor $\gamma$ may require the use of numerical methods. $\gamma$ is a factor dependant on the geometrical configuration of the probes of a four-point probe as described elsewhere in the present specification.

According to the teachings of the present invention, the method according to the first aspect may further include performing a measurement for calculating resistance of said test sample using the correction factor.

After calculating the correction factor for a given configuration of the probe arms the probe arms are preferably not moved while performing the above-mentioned measurements and calculations. The sheet resistance may then be calculated using the correction factor as calculated above. Although the second four-point resistance is used as described above, the first four-point resistance may alternatively be used for calculating the sheet resistance of the test sample.

Advantageously, the probes may be repeatedly moved to a remote position and the steps of claim 1 and 2 are repeatedly performed for each position.

It may be necessary to determine the sheet resistance of the test sample at multiple positions and the test probe may then be stepwise moved to these locations where the calculation of the correction factor may be performed and the subsequent measurement or determination of the sheet resistance is formed.

A second aspect of the present invention relates to a method for performing resistance measurements using four-point probes using an improved correction factor for reduction or elimination of positional errors, said four-point probe having a body and four probe arms each including a probe, said probe arms extending parallel from said body, said four-point probe including electrical contact points for establishing electrical contact between said probes and a test apparatus transmitting and receiving electrical signals, said method comprising the steps of:

positioning said probe arms in contact with a surface of said test sample,
selecting a first set comprising a first and a second probe arm and a second set comprising a third and a fourth probe arm,
applying a first current from said test apparatus through said first probe arm of said first set to said second probe arm of said first set, said first current propagating through said test sample,
detecting a first induced voltage at said third and fourth probe arms of said second set,
calculating a first four-point resistance, $R_{first}$, based on a ratio of said first voltage and said first current,
selecting a third set comprising a first and a second probe arm, wherein said third set includes no more than one of said probe arms of said first set, and a fourth set comprising a third and a fourth probe arm wherein said fourth set includes no more than one of said probe arms of said second set,
applying a second current from said test apparatus through said first probe arm of said third set to said second probe arm of said third set, said second current propagating through said test sample,
detecting a second induced voltage between said third and probe arms of said fourth set,
calculating a second four-point resistance, $R_{second}$, being a ratio of said second voltage and said second current,
calculating a correction factor based on said first and second four-point resistances
calculating resistance of said test sample using said correction factor.

The method according to the second aspect may include any of the features mentioned in relation to the first aspect of the present invention.

A third aspect of the present invention relates to a test apparatus having a first and a second holder for holding a test sample and a test probe, respectively, a memory device for storing a computer implementation of the method according to the first and/or second aspect and a microprocessor for executing the computer implementation of the method according to the first and/or second aspect.

The test apparatus according to the third aspect of the present invention may include any of the features of the method mentioned in relation to the first and/or second aspect of the present invention.

When introducing a test probe to the surface of a test sample, vibration, drift and other disturbances the probe is caused to move relative to the test sample, whereby the probe tip is scraped along the surface of the test sample.

Also, bringing the test probe into contact with the test sample subjects the test probe to wear and thereby limited lifetime for the test probe.

A fourth aspect of the present invention relates to a test probe for at least partly reducing the wear of test test probe in that a probe for testing electrical properties of test samples is provided. The test probe comprises:

a body having a probe arm defining a proximal end and an opposite distal end, the probe arm extending from the body at the proximal end of the probe arm, a first axis defined by the proximal end and the distal end, the probe arm defining a geometry allowing flexible movement of the probe arm along the first axis and along a second axis perpendicularly to the first axis and along a third axis orthogonal to a plane defined by the first axis and second axis.

The geometry defined by the probe arm provides the probe arm with flexible motion so that when the probe is in contact with a test sample, and the test probe is held in a holder of a test apparatus, vibrations from the surroundings are at least to a certain degree absorbed in the arm and not transferred to motion between the probe arm and test sample. This static contact between the test probe and the test sample may be achieved by ensuring that the frictional force is higher that the absolute force applied in the surface plane of the test sample.

When the probe is held in static contact with the test sample rather than the test probe moving relative to the test sample, significant increase in the lifetime of the test probe is achieved. Also, it is contemplated that the quality of tests performed are increased as the conditions under which the test is performed are not changed and the contact area of the test sample remains substantially the same.

In an advantageous embodiment of the present invention, the probe arm may be a supporting structure supporting a contact probe for establishing electrical contact to the test sample, a pad for establishing electrical contact to a test apparatus and an electrical conductive strip positioned on or in the body for establishing electrical contact between the contact probe and the pad.

The above mentioned arrangement is provided for the probe to send and receive electrical signals transmitted to and through the test sample, respectively. The electrical signals may be AC, DC, RF, or any other electrical signal or combinations of signals. Also, the test apparatus may include signal filters, lock-in circuits etc.

In some embodiments of the present invention, the geometry may include a semi-circular part and/or a square part and/or a rectangular part and/or triangular part and/or any combinations thereof. The different geometries, or parts thereof, help allowing flexible movement of the probe arm when the probe is subjected to vibrations and/or drift etc.

In a specific embodiment, the geometry may include two substantially linear parts connected so as to define an angle. Further, the probe arm itself may extend from the body in an angle. The angle or angles may be between 0 and 180 degrees, such as between 55 and 145, e.g. 90 degrees.

The angles and geometries mentioned above apply to any or all of the three dimensions.

Advantageously, the probe arm defines substantially equal spring constants in the direction of the first, the second and the third axis. It is found to be very advantageous for the probe arm to have spring constants that are equal or substantially equal in the three dimensions.

In a further embodiment, the body may include a plurality of probe arms. The plurality of probe arms allows for multi-point probe measurements, e.g. four-point probe measurements.

In an even further embodiment of the present invention, the plurality of probe arms may define similar geometries or in the alternative at least two different geometries. In some applications it could be contemplated to have probe arms defining substantially identical or similar geometries, e.g. for having a plurality of probe arms located closely together while defining a line at the probe tips.

In a still further embodiment a probe having probe arms defining different geometries in order to have a plurality of probe arms for positioning a multitude of probe tips closely together without defining a line may be used. Other applications may be envisioned.

In an even still further embodiment of the present invention the probe, when in use, may define spring constants that, when projected onto a plane of a surface of the test sample are substantially equal, or define a ratio between 1:1 to 1:20. When the test probe have been brought into contact with the surface of the test sample an angle is defined between the test probe and the test sample surface. The angle may be between 0 and 180 degrees, usually around 45 degrees. The probe arms have or define spring constants as described else were, when these spring constants are projected onto a plane defined by the surface of the test sample the projected spring constants is preferably substantially equal. However it have been found that the spring constants may also have a ratio between 1:1 to 1:20, such a 1:2 to 1:15, such as 1:3 to 1:10, such as 1:4 to 1:6, such as 1:1 to 1:2, such as 1:2 to 1:3, such as 1:3 to 1:4, such as 1:4 to 1:5, such as 1:5 to 1:8, such as 1:8 to 1:10, such as 1:10 to 1:15, such as 1:15 to 1:20.

A fifth aspect of the present invention relates to a test probe for testing electrical properties of test samples. The test probe according to the fifth aspect may comprise:

a body comprising an electrical conductive contact for establishing electrical contact to the test sample, the body being flexibly suspended by spring means so as to allow the probe to establish static contact with the surface of the test sample.

The test probe may be suspended e.g. by springs or other structural elements allowing the probe to be suspended in a flexible manner so that static contact may be established between the test probe and the test sample surface.

Further, the test probe according to the fifth aspect of the present invention may include any of the features mentioned in relation to the first, second, third and/or fourth aspect.

The present invention is now to be described with reference to the attached schematic illustrations, in which:

Fig. 1 is a schematic illustration of positions of four probes and distances between them,
Fig. 2 is a schematic illustration of four probes positioned on the surface of a test sample,
Figs. 2a-2c are schematic illustrations of three configurations of four-point probes and distances between the probes,
Fig. 3 is a schematic illustration of a logarithmic functions of $\alpha$, $\beta$ and $\gamma$ as a function of b/a, with c = a,
Fig. 4 is a schematic illustration of a numerical simulation of error due to barrier parallel to the in-line direction,
Fig. 5 is a schematic illustration of numerical simulation of measurement errors on a rectangular sample,
Fig. 6 is a view of a probe tip,
Fig. 7 is a schematic illustration of a probe and a test sample,
Fig. 8 is a schematic illustration of a co-ordinate system,
Fig. 9 is an illustration of a probe having a plurality of probe arms,
Fig. 10-12 are different schematic illustrations of a probe having two probe arms, and
Fig. 13 is a schematic illustration of a probe having four probe arms.

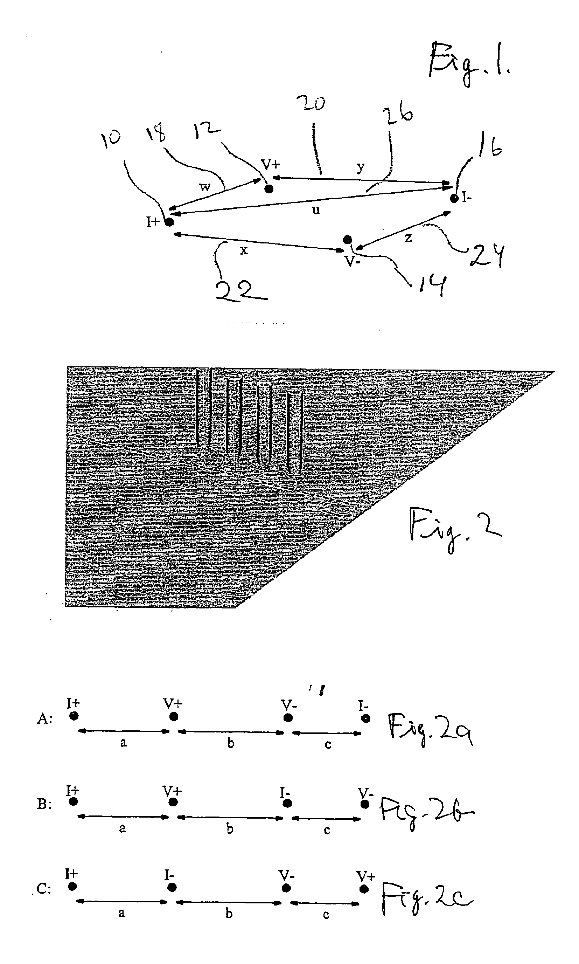

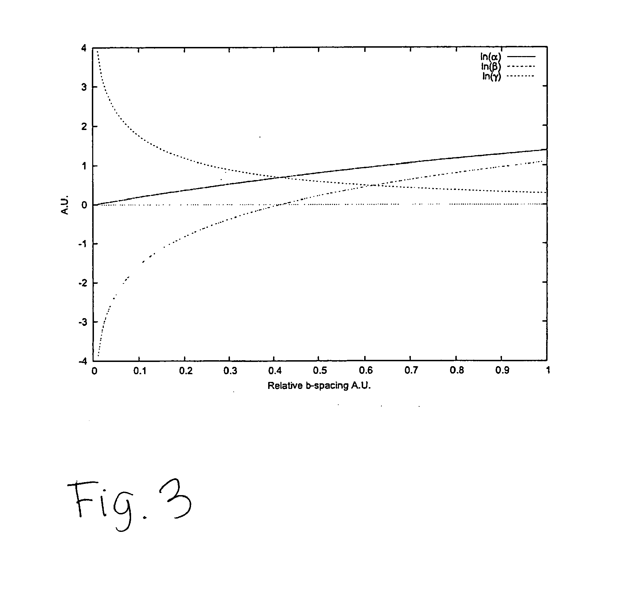

Fig 1. schematically illustrates a four-point probe in contact with the surface. When a multi-point probe, such as a four-point probe, is freely suspended, the arms constituting the point probes are freely extending from the body of the multi-point probe and as such, in theory at least, are positioned in-line with the known distance between the end points of the probe is brought into contact with the surface of the sample. The arms are displaced relative to each other partly due to surface errors or surface irregularities and possibly also due to the probes position relative to the surface of the sample. The spacing between the probes may vary due to uncertainty in production or vibrations.The difference in the relative spacing of the probes are illustrated in fig. 1 in that four probe arms (10,12,14,16) are displaces relative to each other and where in between distances illustrated by the arrows (2,22, 24,26).

Assuming that the four-point probes (10,12,14,16) are positioned in-line and with known spacing on the surface of the test sample will result in an imprecise or erroneous measurement as the current distribution and current and all voltage measured is different from the theoretical assumptions.

For an infinite sheet the four-point voltage to current ratio may be expressed as

$$R_{4pp} = \frac{V}{I} = \frac{R_s}{2\pi}\ln\left(\frac{xy}{wz}\right),$$

where *w*, *x*, *y* and *z* are distances as given in figure 2 and $R_s$ is the sheet resistance of the sheet. A total of 24 perturbations of interchanging electrodes exist, however these 24 pertubations can be devided into 3 groups each consisting of 8 equivalent configurations. Within each group the measured four-point resistance will differ at most by a change of sign. The four-point resistance for each group is designated $R_A$, $R_B$ and $R_C$. These ratios are so defined that they always are positive. The following relation exists between the four-point resistances.

$$R_A = R_B + R_C$$

For linear configurations representative configurations for each of these groups are illustrated in figs. 2a to 2c. The voltage-to-current ratio for these configuration are given as

$$R_A = \frac{V_A}{I_A} = \frac{R_s}{2\pi}\ln\alpha$$

$$R_B = \frac{V_B}{I_B} = \frac{R_s}{2\pi}\ln\beta \;,$$

$$R_C = \frac{V_C}{I_C} = \frac{R_s}{2\pi}\ln\gamma$$

where the parameters $\alpha, \beta$ and $\gamma$ are given by

$$\alpha = \frac{(a+b)(b+c)}{ac}$$

$$\beta = \frac{b(a+b+c)}{ac} \;,$$

$$\gamma = \frac{(a+b)(b+c)}{b(a+b+c)}$$

With manipulation it can be found that the following relations exist between the parameters

$$\alpha = \beta+1 = \frac{\gamma}{\gamma-1} = \beta\gamma$$

$$\beta = \alpha - 1 = \frac{1}{\gamma - 1} = \frac{\gamma}{\alpha}$$

$$\gamma = \frac{\alpha}{\alpha-1} = \frac{\beta+1}{\beta} = \frac{\alpha}{\beta}$$

Performing two measurements using the configuration illustrated in fig 2A and the configuration illustrated in fig. 2C we can make the following relation

$$\frac{R_A}{R_C} = \frac{R_s/2\pi\ln\alpha}{R_s/2\pi\ln\gamma},$$

and using the above relations, we can reduce this to

$$\frac{R_A}{R_C} = 1 - \frac{\ln(\gamma - 1)}{\ln\gamma}.$$

Thus we can uniquely determine $\gamma$ from the ratio $R_A$ to $R_C$. Due to the complexity of the relation $\gamma$ must be found using numerical methods. This task may be performed using suitable routines from programmes for numerical solution of equations, eg. MINPACK. When $\gamma$ has been determined we may calculate the sheet resistance from

$$R_s^{AC} = \frac{2\pi}{\ln\gamma} R_C,$$

where the index *AC* indicates that the sheet resistance is based on the A and C configurations. In principle any other ratio of two of $R_A$, $R_B$ and $R_C$ can be used to find any of the three parameters $\alpha$, $\beta$ or $\gamma$, and the sheet resistance can be found using the appropriate relation.

Since the spacing *a*, *b* and *c* are eliminated the method will find the correct sheet resistance independent of the real spacings. Thus any variation in positioning of the electrodes are also eliminated.

At least the following relation between four-point resistances and possible search parameter exist:

a1: $R_A/R_B = \ln(\alpha)/\ln(\alpha-1)$
b1: $R_A/R_B = \ln(\beta+1)/\ln(\beta)$
c1: $R_A/R_B = -\ln(\gamma-1)/\ln(\gamma)$
d1: $R_A/R_c = \ln(\alpha)/(\ln(\alpha)-\ln(\alpha-1))$
e1: $R_A/R_c = \ln(\beta+1)/\ln(1+1/\beta)$
f1: $R_A/R_c = 1-\ln(1-\gamma)/\ln(\gamma)$
g1: $R_B/R_C = \ln(\alpha-1)/(\ln(\alpha)-\ln(\alpha-1))$
h1: $R_B/R_C = \ln(\beta)/(\ln(\beta+1)-\ln(\beta))$
i1: $R_B/R_C = -\ln(\gamma-1)/\ln(\gamma)$

Further each relation may in the implementation be represented by its reciprocal expression. In some configurations of the four-point measurement a change of sign will be needed.

The sheet resistance may be given by either of the following relations:

a2: $R_{sq} = R_A\, 2\pi/\ln(\alpha)$
b2: $R_{sq} = R_A\, 2\pi/\ln(\beta+1)$
c2: $R_{sq} = R_A\, 2\pi/\ln(\gamma/(\gamma-1))$
d2: $R_{sq} = R_B\, 2\pi/\ln(\alpha-1)$
e2: $R_{sq} = R_B\, 2\pi/\ln(\beta)$
f2: $R_{sq} = -R_B\, 2\pi/\ln(\gamma-1)$
g2: $R_{sq} = R_C\, 2\pi/\ln(\alpha/(\alpha-1))$
h2: $R_{sq} = R_C\, 2\pi/\ln((\beta+1)/\beta)$
i2: $R_{sq} = R_C\, 2\pi/\ln(\gamma)$

Any two of these relations one from the first group and one from the second group both containing the same parameter $\alpha$, $\beta$ or $\gamma$ will constitute a functional implementation of the method, eg. a1 and g2, or e1 and b2 . These relation may be derived from the previously equations. Further each of these relations may be modified by imposing $R_A = R_B + R_C$.

Isolation of search parameter in second group and insertion in first group will also constitute a valid implementation.

Fig. 3 is a schematic illustration of a logarithmic functions of $\alpha$, $\beta$ and $\gamma$ as a function of b/a, with c = a.

The method according to the present invention of eliminating errors due to error positioning in the in-line direction, does not increase the sensitivity to other errors such as electromagnetic radiation and positioning errors perpendicular to the in-line direction.

Errors due to electromagnetic radiation and cross-over from current source to voltage sensors eg. due to variation in contact resistance, we can assume to result in stocatic variations directly on the measured voltage-to-current ratio. Thus we can describe the sensitivity for the normal four-point probe method simply as

$$\frac{\partial R_{_B}}{\partial R_A} = \frac{2\pi}{\ln\alpha},$$

and equivalently for the B and C configurations. For the presented method we have the following expression

$$\frac{\partial R^{AC}_{_s}}{\partial R_A} = -\frac{2\pi}{\alpha\ln^2\alpha}R_A\frac{\partial\alpha}{\partial R_A} + \frac{2\pi}{\ln\alpha}.$$

We will use $R_A/R_C$ to find $\alpha$ from

$$\frac{R_A}{R_C} = \frac{\ln\alpha}{\ln\left(\frac{\alpha}{\alpha-1}\right)}.$$

By differentiating both sides with respect to $R_A$ and performing manipulation we find

$$\frac{\partial\alpha}{\partial R_A} = \frac{(\alpha^2 - \alpha)\ln^2\frac{\alpha}{\alpha-1}}{R_C\left(\ln\alpha + (\alpha - 1)\ln\frac{\alpha}{\alpha-1}\right)}.$$

By inserting equation 2 into 1 and assuming that we know $\alpha$ from the nominal electrode spacings, we find that the ratio

$$f_{ACA} = \frac{\partial R^{AC}_{_s}/\partial R_A}{\partial R_{_s}/\partial R_A}$$

is always between 0 and 1 meaning that the presented method always gives better or the same sensitivity compared to the simple method of using directly the nominal spacing. For a symmetric probe spacings with $a = b = c$ we find that the ratio $f_{ACA}$ is 0.616, an improvement of approximately 40%. Unfortunately the ratio for the AC configuration sensitivity towards variations in $R_C$ $f_{ACC}$ is 1.894 indicating that the corrected method is almost two times as sensitive to variations in $R_C$ as the uncorrected is towards variations in $R_A$. Overall the sensitivity towards variations in the voltage-to-current ratios is increased approximately by a factor of 2. This may appear to be a problem, however, since in real life measurements the measurements error is dominated by positioning errors, at least for microscopic four-point probes, the method is still an improvement over the non-corrected method.

Further it is our experience that the *relative* rather than the absolute noise is the same for $R_A$ and $R_C$. Using that information we can write the noise in the corrected sheet resistance

$$\sigma_{R_s}^{rel,c} = \frac{1}{R_s}\sqrt{(f_{ACC}R_C)^2\left(\sigma_R^{rel}\right)^2 + (f_{ACA}R_A)^2\left(\sigma_R^{rel}\right)^2},$$

$$= \sigma_R^{rel}\sqrt{\left(f_{ACC}\frac{\ln\frac{a}{a-1}}{2\pi}\right)^2 + \left(f_{ACA}\frac{\ln a}{2\pi}\right)^2}$$

where $\sigma_{R_s}^{rel,c}$ and $\sigma_R^{rel}$ is the relative standard deviation in the corrected sheet resistance and the relative standard deviation in the measured voltage-to-current ratios. Again for a symmetric probe this factor $\sigma_{R_s}^{rel,c}/\sigma_R^{rel}$ becomes 0.629. Thus we have an overall noise suppression of 37%.

The voltage-to-current ratios for standard linear four-point probe are to first order insensitive to positioning error in the direction perpendicular to the in-line direction. Thus since the correction method uses directly these ratios it too becomes insensitive to such positioning errors to first order.

Surprisingly, it turns out that the method according to the present invention eliminates the influence of non-conducting barriers parallel to the line on which the electrodes are positioned.

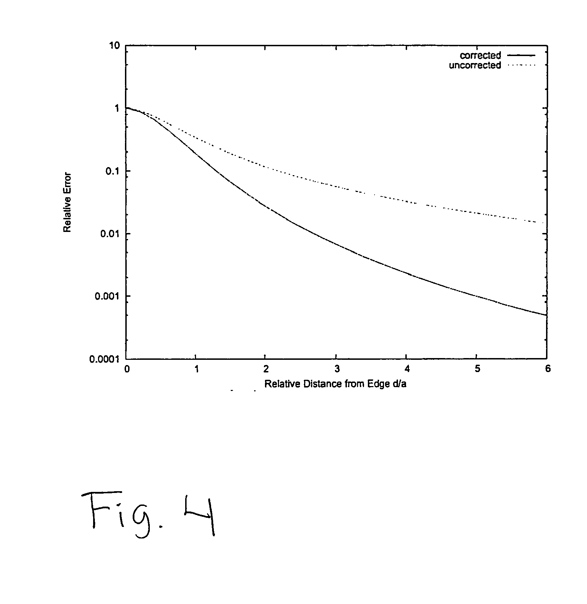

The above findings suggest that it might be possible to eliminate sample shape entirely. However, analytical studies with a barrier along the in-line direction show that this cannot be eliminated. On the other hand numerical studies show that the error is significantly decreased. Fig. 4 shows the simulated measurement error as a function of distance to the barrier. The distance is normalised with respect to the electrode spacings. The probe is assumed to be symmetric with $a = b = c$. The dashed curve shows the measurement error for a non-corrected sheet resistance while the solid curve shows the error for the corrected sheet resistance- As can be seen from the figure the method greatly improves the measurement error. For the corrected sheet resistance the error is less than 1% at a distance of just 3 times the electrode spacing. This situation occurs for the uncorrected sheet resistance at a distance of 7 times the electrode spacing.

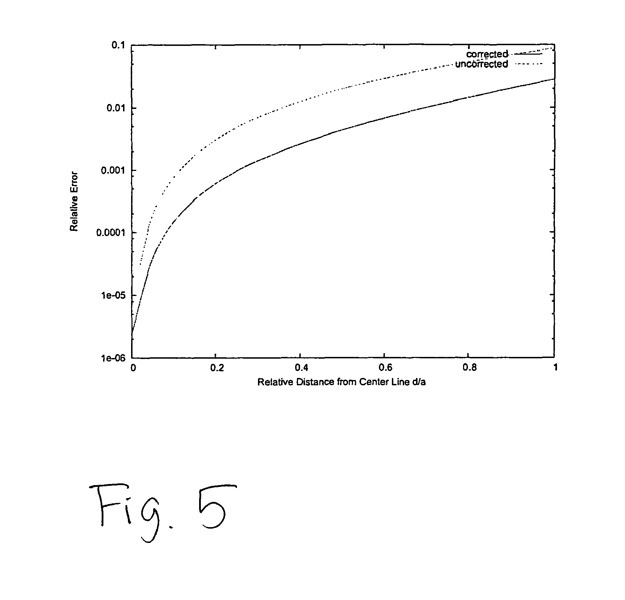

This effect too can be eliminated if the probe is placed in the centre between two parallel barriers, or on a rectangular sample. Fig. 5 shows the error when measuring a rectangular sample.

Again we have assumed a symmetric probe. For the uncorrected sheet resistance we have used a correction factor assuming a known sample dimension and a probe located at the centre of the sample. The sample dimensions are 5 by 5 times the electrode spacings. As seen from the figure the method greatly improves the error due to misalignment of probe position. Further, unlike for the ucncorrected case, it is not needed to know the exact sample dimensions if just the probe is positioned approximately in the middle of the sample.

If the sample has well-known dimensions and is very narrow, the measured value depends only weakly on the position, and the method does not provide any improvement. However, in such case the width of the sample must be known. If width is not known, the correction method is still usable to find approximate correction factors. For large samples the measurement is improved even more.

Fig. 5 is a schematic illustration of numerical simulation of measurement errors on a rectangular sample. The dashed line shows the uncorrected sheet resistance and the solid line illustrates the corrected sheet resistance.

The sample used for the simulation is a rectangular sample having a side length in the direction parallel to the in-line direction of the 5 times the electrode spacings and a side length perpendicular to the in-line direction of 5 times electrode spacing. The probe is symmetric with a = b = c. For the uncorrected sheet resistance the sample dimensions is assumed to be known and the error is calculated relative to a situation where the probe is located on the centre line.

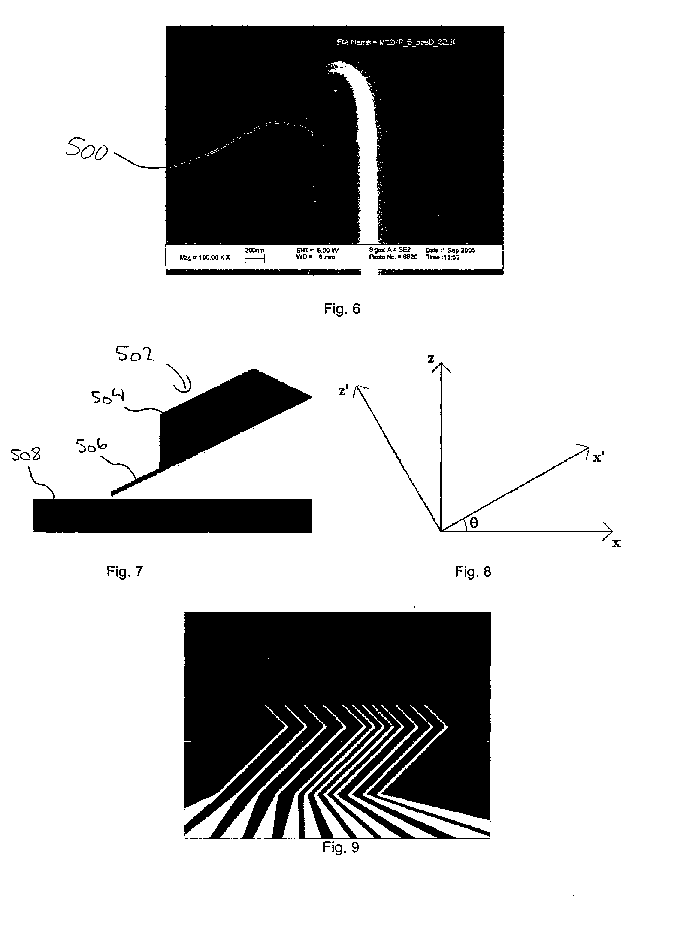

Fig. 6 illustrates the tip 500 of a probe.

In order to increase the lifetime of a probe, the tip wear must be minimised. The wear originates from at least two sources and their individual contributions are unknown. As the cantilever is brought into contact with a surface, the tip scrapes along the surface in the longitudinal direction of the cantilever. During measuring, the contact point is believed to be dynamic, i.e. the tip rubs against the surface due to vibrations and drift.

Fig. 7 schematically illustrates a probe 502 having a body 504 and a probe arm 506 extending from the body 504. The probe 502 is brought into contact with the surface of a test sample 508. At the end of the probe arm 506, a probe is provided for establishing electrical contact to the surface of the test sample 508 so that tests for determining the electrical properties of the test sample 508 may be performed.

When the tip of the probe arm 506 is in contact with the surface of the test sample 508, vibrations and drift in the system holding the test probe 502 and the test sample 508 will cause the tip of the probe 502 to move or scrape along the surface of the test sample 508 causing wear to the tip of the probe 502.

A reference co-ordinate system is illustrated in Fig. 8, where the x' and z' axis illustrate the position of the probe and the x and z axis illustrate the position of the test sample. An angle θ is defined between the test sample and the test probe.

In order to reduce this wear a probe according to the present invention is provided in order to create a static contact, both during engaging and during measuring. The cantilevers are given a third dimension of freedom such that each cantilever has a balanced spring constant of ($k_x$, $k_y$, $k_z$) ~ (k, k, k). Unlike conventional micro-four-point probes, vibrations/movements may be absorbed in all directions.

In order to obtain a static contact, the friction force must be higher than the absolute force applied in the surface plane.

$$ F_f > \left| \mathbf{F}_x \right| \tag{I} $$

The friction force is given by the product of the static friction coefficient and the normal force.

$$ F_f = \mu_s \cdot \mathbf{N} = -\mu_s \cdot \mathbf{F}_z \tag{II} $$

The forces acting as a result of an engage depth, $d$, is given by:

$$ \mathbf{F}_z = \mathbf{F}_{x'} \cdot \hat{\mathbf{z}} + \mathbf{F}_{z'} \cdot \hat{\mathbf{z}} = -d \cdot \left( k_{x'} \cdot \sin^2 \theta + k_{z'} \cdot \cos^2 \theta \right) \tag{III} $$

$$ \mathbf{F}_x = \mathbf{F}_{x'} \cdot \hat{\mathbf{x}} - \mathbf{F}_{z'} \cdot \hat{\mathbf{x}} = -d \cdot \left( k_{x'} - k_{z'} \right) \cdot \sin \theta \cdot \cos \theta \tag{IV} $$

(I), (II), (III) and (IV) reduces to the inequality:

$$ \mu_s \cdot \left( A \cdot \tan \theta + \frac{1}{\tan \theta} \right) > \left| A - 1 \right| \tag{V} $$

$$ A = \frac{k_{x'}}{k_{z'}} \tag{IV} $$

It is obvious that the inequality is satisfied for $A \rightarrow 1$. This means that the cantilever spring constants should be equal in absolute value. This can be achieved by a number of different approaches. The formulation can be expanded for 3 dimensions.

Fig. 9-11 illustrate different embodiments of probe arms contemplated to fulfil the requirements stated above.

Fig. 9 illustrates a probe having a plurality of probe arms comprising two substantially straight or linear parts connected at an angle of approximately 90 degrees. The arms extend from a probe body at an angle.

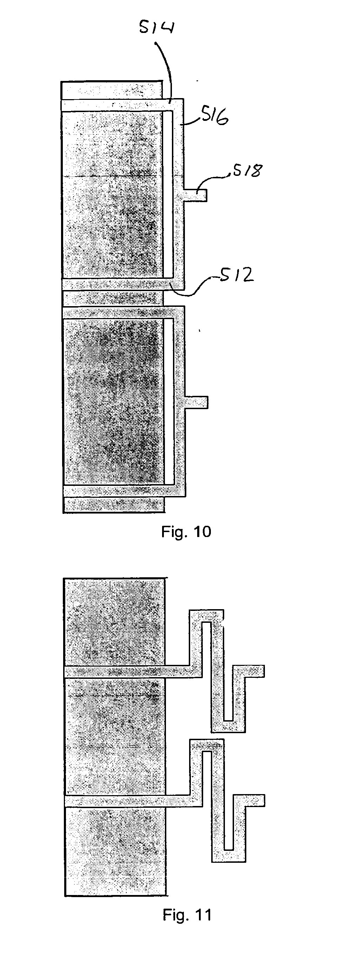

Fig. 10 schematically illustrates an embodiment of a probe according to the present invention where two probe arms are formed, each having two parts 512 and 514 connected to the body 510, and a part 516 interconnecting the two parts 512, 514. A flexible contact part 518 is provided at the part 516. The probe arm is preferably formed as an integral part, all of which are considered part of the present invention.

Fig. 11 schematically illustrates an embodiment of a probe according to the present invention where two probe arms are formed each having a structure including a square wave-like geometry. Also embodiments having more than one period of the square wave-like geometry may be envisioned, as well as square wave-like geometries with varying periodicity. All of which is considered part of the present invention.

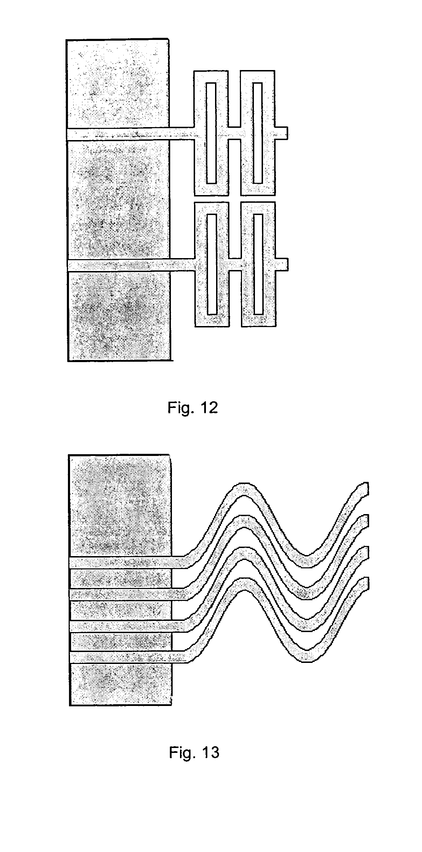

Fig. 12 schematically illustrates an embodiment of a probe according to the present invention where two probe arms are formed each having a structure including two rectangular parts with an aperture formed therein. Embodiments having only one rectangle may be envisioned as well as embodiments having more than two rectangles, both of which are considered part of the present invention.

Fig. 13 schematically illustrates an embodiment of a probe according to the present invention where four probe arms are formed each having a structure including a sinusoidal geometry. Embodiments where the sinusoidal geometry have a varying periodicity are considered part of the present invention.

When using probes having the above mentioned and above described geometries the contact between the probe and the test sample remains static and the probe lifetime increases significantly. The same effect may be achieved by similar geometries.

In still further embodiments of the present invention, a probe may be suspended by use of springs, or the like, in order to achieve the same effect as described above in relation to other embodiments of the present invention.

The present invention may be characterised by the following points:

1. A method for calculating a correction factor for reduction of positional errors in resistance measurements using four-point probes, said four-point probe having a body and four probe arms each including a probe, said probe arms extending parallel from said body, said four-point probe including electrical contact points for establishing electrical contact between said probes and a test apparatus transmitting and receiving electrical signals, said method comprising the steps of:

positioning said probe arms in contact with a surface of said test sample,
selecting a first set comprising a first and a second probe arm and a second set comprising a third and a fourth probe arm,
applying a first current from said test apparatus through said first probe arm of said first set to said second probe arm of said first set, said first current propagating through said test sample,
detecting a first induced voltage between said third and probe arms of said second set,
calculating a first four-point resistance, $R_{first}$ being a ratio of said first voltage and said first current,
selecting a third set comprising a first and a second probe arm, wherein said third set includes no more than one of said probe arms of said first set, and a fourth set comprising a third and a fourth probe arm wherein said fourth set includes no more than one of said probe arms of said second set,
applying a second current from said test apparatus through said first probe arm of said third set to said second probe arm of said third set, said second current propagating through said test sample,
detecting a second induced voltage at said third and probe arms of said fourth set,
calculating a second four-point resistance, $R_{second}$, being a ratio of said second voltage and said second current,
calculating a correction factor based on said first and second four-point resistance.

2. The method according to point 1, wherein said method further includes:

performing a measurement for calculating resistance of said test sample using said correction factor.

3. The method according to point 2, wherein said probed is repeatedly moved to a remote position and said steps of point 1 and 2 are repeatedly performed for each position.

4. A method for performing resistance measurements using four-point probes using a correction factor for reduction or elimination of positional errors, said four-point probe having a body and four probe arms each including a probe, said probe arms extending parallel from said body, said four-point probe including electrical contact points for establishing electrical contact between said probes and a test apparatus transmitting and receiving electrical signals, said method comprising the steps of:

positioning said probe arms in contact with a surface of said test sample,
selecting a first set comprising a first and a second probe arm and a second set comprising a third and a fourth probe arm,
applying a first current from said test apparatus through said first probe arm of said first set to said second probe arm of said first set, said first current propagating through said test sample,
detecting a first induced voltage at said third and fourth probe arms of said second set,
calculating a first four-point resistance, $R_{first}$, being a ratio of said first voltage and said first current,
selecting a third set comprising a first and a second probe arm, wherein said third set includes no more than one of said probe arms of said first set, and a fourth set comprising a third and a fourth probe arm wherein said fourth set includes no more than one of said probe arms of said second set,

applying a second current from said test apparatus through said first probe arm of said third set to said second probe arm of said third set, said second current propagating through said test sample,

detecting a second induced voltage between third and probe arms of said fourth set,

calculating a second four-point resistance, $R_{second}$, being a ratio of said second voltage and said second current,

calculating a correction factor based on said first and second four-point resistances

calculating resistance of said test sample using said correction factor.

5. The method according to point 4, wherein said probed is repeatedly moved to a remote position and said steps of point 4 are repeatedly performed for each position.

6. A test apparatus having a first and a second holder for holding a test sample and a test probe, respectively, a memory device for storing a computer implementation of the method according to point 1 and/or point 4 and a microprocessor for executing the computer implementation of the method according to point 1 and/or point 4.

**Claims**

1. A probe for testing electrical properties of test samples comprising:

   a body having a probe arm defining a proximal and an opposite distal end, said probe arm extending from said body at said proximal end of said probe arm, a first axis defined by said proximal and said distal end, said probe arm defining a geometry allowing flexible movement of said probe arm along said first axis and along a second axis perpendicularly to said first axis and along a third axis orthogonal to a plane defined by said first axis and second axis.

2. The probe according to claim 1, wherein said probe arm is a supporting structure supporting a contact probe for establishing electrical contact to said test sample, a pad for establishing electrical contact to a test apparatus, an electrical conductive strip positioned on or in said body for establishing electrical contact between said contact probe and said pad.

3. The probe according to claim 1 or 2, wherein said geometry includes a semi-circular part and/or a square part and/or a rectangular part and/or triangular part and/or any combinations thereof.

4. The probe according to claim 1 or 2, wherein said geometry includes two substantially linear parts connected so as to define an angle.

5. The probe according to any of the claims 1-4, wherein said probe arm defines substantially equal spring constants in the direction of said first, second and third axis.

6. The probe according to any of the claims 1-5, wherein said body includes a plurality of probe arms.

7. The probe according to claim 6, wherein said plurality of probe arms define similar geometries or in the alternative at least two different geometries.

8. The probe according to any of the claims 1-7, wherein the probe, when in use, defines spring constants that, when projected onto a plane of a surface of said test sample are substantially equal, or define a ratio between 1:1 to 1:20.

9. A test probe for testing electrical properties of test samples comprising:

   a body comprising an electrical conductive contact for establishing electrical contact to said test sample, said body being flexibly suspended by spring means so as to allow said probe to establish static contact with said surface of said test sample.

10. The test probe according to claim 9, wherein said probe includes any of the features of the claims 1-8.

Fig. 1.

Fig. 2

A: I+ V+ V- I-  Fig. 2a

B: I+ V+ I- V-  Fig. 2b

C: I+ I- V- V+  Fig. 2c

Fig. 3

Fig. 4

Fig. 5

500

Fig. 6

502
504
508
506

Fig. 7

Fig. 8

Fig. 9

514

516

518

512

Fig. 10

Fig. 11

Fig. 12

Fig. 13

**European Patent Office**

**EUROPEAN SEARCH REPORT**

Application Number

EP 05 38 8093

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/072452 A1 (ELDRIDGE BENJAMIN N ET AL) 15 April 2004 (2004-04-15) <br> * figures 1B,1C,2A-4C,12F,13A,13B * <br> * paragraphs [0004], [0013], [0017] * <br> * paragraphs [0020], [0021], [0094] * <br> * paragraph [0096] * <br> * paragraph [0100] - paragraph [0103] * <br> * paragraph [0105] - paragraph [0113] * | 1-10 | G01R1/067 |
| X | US 2003/102878 A1 (MONTOYA THOMAS T) 5 June 2003 (2003-06-05) <br> * figures 2A,4D,5A-5E,7A * <br> * paragraphs [0011], [0078], [0082] * <br> * paragraph [0085] * <br> * paragraph [0100] - paragraph [0101] * | 1-10 | |
| X | WO 2005/031376 A (MICROFABRICA INC) 7 April 2005 (2005-04-07) <br> * figures 7A,7B,8C,8G,8H,9A,9E-9G * <br> * paragraphs [0006], [0057] * <br> * paragraph [0082] - paragraph [0086] * <br> * paragraph [0094] * | 1-10 | |
| X | US 6 672 875 B1 (MATHIEU GAETAN L ET AL) 6 January 2004 (2004-01-06) <br> * figures 1,2,22f,22g,26a,29a-29d * <br> * column 4, line 25 - line 47 * | 1-10 | TECHNICAL FIELDS SEARCHED (IPC) <br><br> G01R |
| X | US 2001/012739 A1 (GRUBE GARY W ET AL) 9 August 2001 (2001-08-09) <br> * figures 1,2A,2B,3,9A,8F * <br> * paragraph [0046] - paragraph [0051] * | 1-10 | |
| X | US 4 383 217 A (SHIELL ET AL) 10 May 1983 (1983-05-10) <br> * figures 1,8,9 * <br> * column 6, line 29 - line 55 * | 9 | |

-/--

The present search report has been drawn up for all claims

| Place of search | Date of completion of the search | Examiner |
|---|---|---|
| Berlin | 29 March 2006 | Höller, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 780 550 A1**

### European Patent Office

# EUROPEAN SEARCH REPORT

Application Number

EP 05 38 8093

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 085 327 A (PETERSEN, CHRISTIAN LETH; QUAADE, ULRICH; NIELSEN, PETER FOLMER; GREY,) 21 March 2001 (2001-03-21)<br>* figures 1,2,7,8,13-16 *<br>* paragraphs [0001], [0013], [0015] *<br>* paragraph [0082] - paragraph [0088] *<br>* paragraph [0103] * | 1-10 | |
| A,D | US 2004/183554 A1 (WORLEDGE DANIEL) 23 September 2004 (2004-09-23)<br>* the whole document * | 1 | |

TECHNICAL FIELDS
SEARCHED    (IPC)

The present search report has been drawn up for all claims

| Place of search | Date of completion of the search | Examiner |
|---|---|---|
| Berlin | 29 March 2006 | Höller, H |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 05 38 8093

This annex lists the patent family members relating to the patent documents cited in the above-mentioned European search report.
The members are as contained in the European Patent Office EDP file on
The European Patent Office is in no way liable for these particulars which are merely given for the purpose of information.

29-03-2006

| Patent document cited in search report | Publication date | Patent family member(s) | Publication date |
|---|---|---|---|
| US 2004072452 A1 | 15-04-2004 | NONE | |
| US 2003102878 A1 | 05-06-2003 | NONE | |
| WO 2005031376 A | 07-04-2005 | NONE | |
| US 6672875 B1 | 06-01-2004 | AU 2038000 A<br>CN 1329721 A<br>DE 69908638 D1<br>DE 69908638 T2<br>EP 1135690 A2<br>JP 2002531915 T<br>JP 2004186670 A<br>TW 589453 B<br>WO 0033089 A2<br>US 6491968 B1 | 19-06-2000<br>02-01-2002<br>10-07-2003<br>29-04-2004<br>26-09-2001<br>24-09-2002<br>02-07-2004<br>01-06-2004<br>08-06-2000<br>10-12-2002 |
| US 2001012739 A1 | 09-08-2001 | NONE | |
| US 4383217 A | 10-05-1983 | NONE | |
| EP 1085327 A | 21-03-2001 | CA 2381803 A1<br>WO 0120347 A1<br>JP 2003509695 T | 22-03-2001<br>22-03-2001<br>11-03-2003 |
| US 2004183554 A1 | 23-09-2004 | NONE | |

EPO FORM P0459

For more details about this annex : see Official Journal of the European Patent Office, No. 12/82

## REFERENCES CITED IN THE DESCRIPTION

**Patent documents cited in the description**

- US 20040183554 A
- US 6943571 B
- US 4703252 A
- US 5691648 A
- US 6747445 B
- US 20050151552 A
- US 20050081609 A
- US 20050062448 A